Europäisches Patentamt

European Patent Office

Office européen des brevets

(11) Publication number: **0 413 542 A2**

# EUROPEAN PATENT APPLICATION

(21) Application number: **90308888.8**

(22) Date of filing: **13.08.90**

(51) Int. Cl.5: **H01L 23/498**, H01L 21/60

(30) Priority: **15.08.89 US 394042**

(43) Date of publioation of application:
**20.02.91 Bulletin 91/08**

(84) Designated Contracting States:
**DE FR GB IT NL**

(71) Applicant: **TEXAS INSTRUMENTS
INCORPORATED
13500 North Central Expressway
Dallas Texas 75265(US)**

(72) Inventor: **Chiu, Anthony
2563 Buttercup Drive
Richardson, Texas(US)**
Inventor: **Test, Howard
1908 Webster Drive
Plano, Texas 75075(US)**

(74) Representative: **Abbott, David John et al
Abel & Imray Northumberland House 303-306
High Holborn
London, WC1V 7LH(GB)**

(54) Direct mount semiconductor package.

(57) A semiconductor package structure allows testing and includes a fuse link to indicate a short circuit in a semiconductor device before it is incorporated into a circuit. The package structure allows mounting a semiconductor device entire within an opening in a printed circuit board and permits stacking of printed circuit board in a minimum thickness configuration.

*Fig.1*

EP 0 413 542 A2

# DIRECT MOUNT SEMICONDUCTOR PACKAGE

## FIELD OF THE INVENTION

This invention relates to semiconductor devices and more particular to a direct mount packaging and testing technique.

## BACKGROUND OF THE INVENTION

The trend in semiconductor technology is to higher component density on printed circuit boards, higher input/output capability, higher power, speed, reliability and lower cost. To accomplish these advances, at least in part, it has been necessary to reduce the size of the semiconductor devices and to go to various mounting techniques to permit increased density of the printed wiring. A number of techniques have been devised to accomplish these results.

Surface mount components, such as Small Outline Integrated Circuits, Chip Capacitors and Chip Resistors, and Quad Flat Packs can be mounted onto a printed circuit board without using through-holes as required by Dual In-line Packages. Because of the small size of these components, a four to one density improvement can be achieved.

Another level of component density and power/speed increase is achieved through Tape Automated Bonding. In this package, the semiconductor die is bonded to a set of prefabricated leads using either solder reflow or thermal compression bonding techniques similar to wire bonding in conventional Integrated Circuits. A typical 30-60 gram lead pull force for a 4 mil wide lead over a 4 mil bond pad can be accomplished. After bonding one end of a lead to the die, the other end is cut from the tape, formed, and then solder onto the printed circuit board. This type of package form is particularly suitable for high pin count devices. This packaging method has a high material cost for the tape and an added cost for the bond areas on the die, but tends to be less costly than prefab packages such as pin grid arrays for high pin count devices.

The cavity package is used for large semiconductor dies. In this package, the die is mounted into a prefabricated package and the connections between the die and the package is made by wire bonding. This method is used, for example, for Erasable Programmable Read Only Memory. Both ceramic and plastic packages are used.

Chip-on-board packaging has been used commercially. In this assembly, a die is mounted onto the printed circuit board and connection to the board's copper wiring pattern is done by wire bonding.

Flip chip technology uses a die with contact "bumps" on the die. The die is flipped, bumps down, and bonded onto a substrate with matching circuitry. This method is sensitive to the planarity of the bumps and the planarity to the matching wiring on the substrate. Also, passive heat dissipation is difficult to accommodate in this type of package.

Hybrid circuit technology mounts a die onto a substrate with preprinted interconnects and the die is connected to the substrate by wire bonding or flip-chip technology. The assembly cost of this package is the highest of all the above mentioned packages.

## BRIEF SUMMARY OF THE INVENTION

The invention is to a semiconductor device packaging and a burn-in and test structure on the semiconductor mounting material. Copper conductors are formed on a flexible base material such as polyimide. There are continuous conductors on the flexible base material that run the length thereof to serve, in burn-in and testing, as power and ground connections for each semiconductor device mounted on the flexible base material. Other conductors and connections on the base material include test points for testing each device before it is mounted on a printed circuit board, bond pads for connecting the semiconductor device to the base material and interconnections for connecting the device and a portion of the base material having interconnections thereon to a printed circuit board. It is not necessary to remove the semiconductor device from the tape base before it is mounted. In some applications, it may be easier to mount the semiconductor device prior to cutting it from the tape base. The circuit board may have one of more layers in which through holes in some layers may be connected to circuitry and interconnect pads on the base layer.

Provisions are made such that once a device is mounted on a circuit board, and the device needs to be replaced, the device and base material may be cut from the circuit board and a new device is placed on top of a portion of the old base material and the new device connected to bond pads on the old base material.

The circuit board on which the device is to be mounted has an opening through the board to accommodate the device. The opening may be prepunched before the printed circuitry is formed on the circuit board, or after by laser machining.

At assembly, the device is aligned to the lead pattern on the printed circuit board and bonded to contact pads connected to the circuitry on the printed circuit board. A heat sink may be attached to the device on one side and a protective covering is attached to the other side of the device.

Prior to removing the device and connections from the film base, the device may be tested using test points on the film connected to the connections to the device.

The technical advance represented by the invention as well as the objects thereof will become apparent from the following description of a preferred embodiment of the invention when considered in conjunction with the accompanying drawings, and the novel features set forth in the appended claims.

## BRIEF DESCRIPTION OF THE DRAWINGS

FIGURE 1 illustrates integrated circuits mounted on a flexible base with test points;

FIGURE 2 illustrates a printed circuit board on which a semiconductor device of the present invention may be mounted;

FIGURE 3 shows a semiconductor device mounted on printed circuit board;

FIGURE 4 is a cross-sectional view of a semiconductor device mounted on a circuit board;

FIGURE 5 illustrates a module of stacked circuit boards; and

FIGURE 6 illustrates an example of a high density memory stacked array without a heat sink.

## DESCRIPTION OF A PREFERRED EMBODIMENT

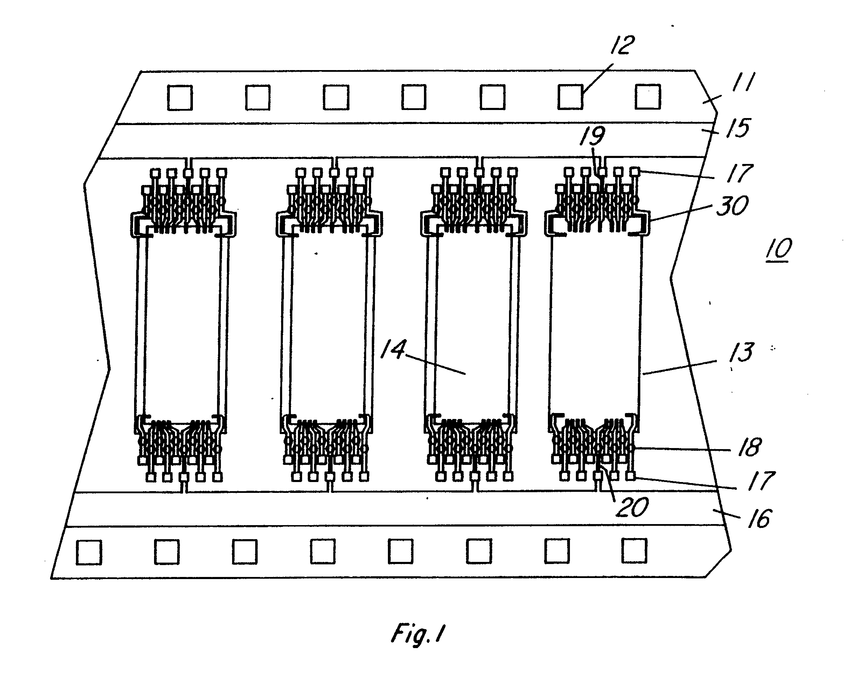

Figure 1 illustrates a strip carrier 10 having conductive material formed thereon in a desired pattern. The conductive pattern includes two continuous conductors 15 and 16, one on each side of the tape, test points 18, and interconnection patterns 20. The flexible film 11 is, for example, polyimide which has sprocket holes 12 extending along each side. Openings 13 are spaced along the film 11 to accommodate the mounting of semiconductor devices which are to be mounted on the film 11, and attached to the interconnection patterns 30.

Interconnections 30 are formed on the film base and extend over the opening 13 such that the ends of the interconnections may be connected to a semiconductor device placed in the opening 13. The ends of the interconnections may be bonded, for example by compression bond, to bond/contact pads on the semiconductor device 14.

Also on the film base 13, and connected to the conductors 30, are test points 17. After mounting a semiconductor device on the film base and interconnecting the bond pads of the device to the circuitry 30, the device 14 may be tested to ensure that it is an operable device before it is to be mounted on a circuit board.

There are two fuse links 19 and 20 which are connected to test points and connecting circuitry. Fuse link 19 is connected to continuous conductor 15, and fuse link 20 is connected to continuous conductor 16. If, for example, continuous conductor 15 is a power connection for a device and continuous conductor 16 is a ground connection, then when power is applied to continuous conductor 15, if a device has an internal short, either fuse link 19 or 20 will be blown, indicating a defective device 14. By visual inspection, or by electrical continuity testing a blown link can be detected and that device not tested any further.

This fuse link design can be used in wafer burn-in. The power and ground strips can be patterned on the "streets" on the wafer using a single mask or multi-mask for multilayer design.

Connected to the connecting circuitry 30 are conducting pads 18. These pads are connected to bond pads on a printed circuit board to interconnect the semiconductor device 14 to the printed circuit board.

To connect a device mounted on the base 11 to a printed circuit board, the device and interconnections are cut from the film base and mounted as hereinafter illustrated, or the nonfunctional portion of the tape (11, 12, 15, 16, 17, 19, 20) can be cut after the tape has been bonded on to the printed circuit board.

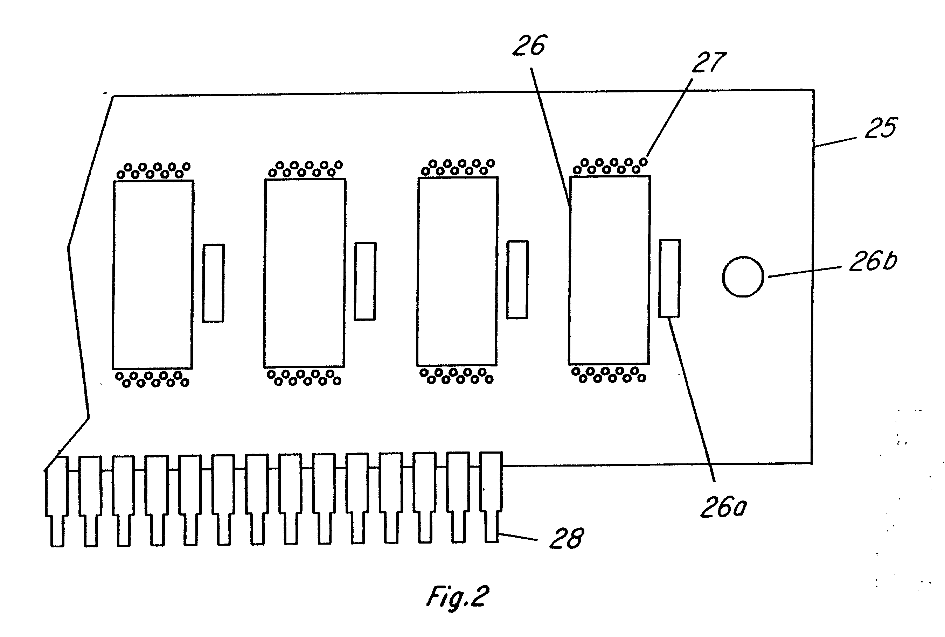

Figure 2 shows part of a printed circuit board 25 having four openings 26 therein. If, for example, the circuit board were to be for a 1 megabyte memory module, an eight opening board would be used. Other openings 26a would be made in the circuit board 25 for passive components such as resistors, capacitors or diodes. One or more tooling and alignment openings 26b also may be formed in the circuit board. At two ends of opening 26 are arrays of conductive bond pads 27. The bond pads 18, Figure 1, connect the semiconductor device 14 to the printed circuitry. No other printed circuitry has been illustrated on circuit board 25 for purposes of clarity, but any desirable circuit configuration may be formed on board 25 to interconnected semiconductor devices mounted in the openings 26 with each other device and other circuitry and components on the circuit board. Board 25 may be either a single or multiple layer board depending on the desired circuitry.

Circuit board 25 may have edge connectors 28 to connect the circuitry on board 25 with a mother board.

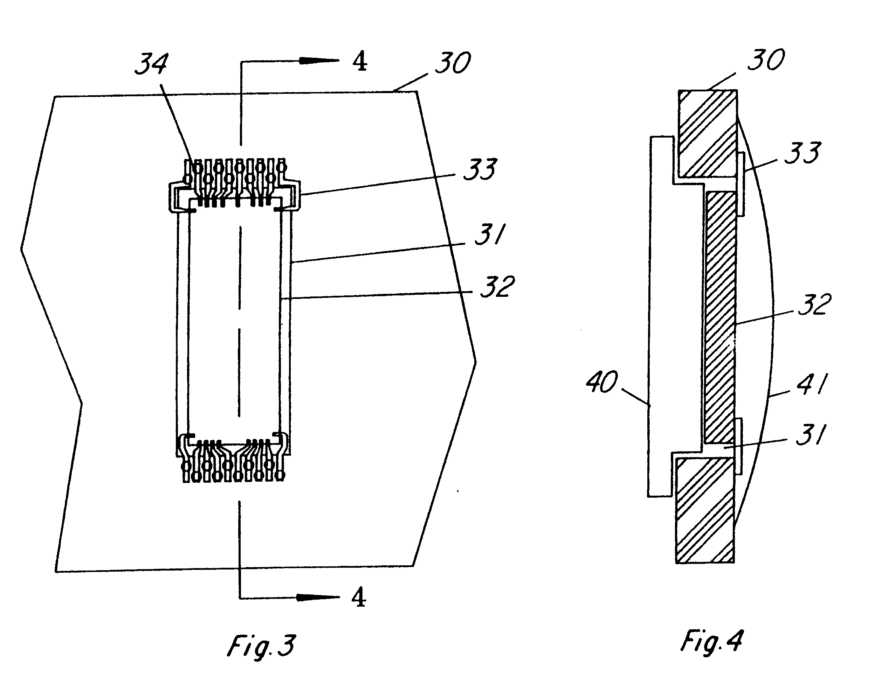

Figure 3 is a partial view of a printed circuit board 30 having a semiconductor 32 mounted thereon. The bond pads 27 on the printed circuit board 25 (Figure 2) are aligned with the bond pads 18 (Figure 1) and then bonded together to form the connections 34. Semiconductor device 32 is within the opening 31 of the printed circuit board 30.

A feature of the invention is that if a device 31 becomes inoperative, the inoperative device may be removed by cutting the connections 33 and a new device 32 may be placed such that the bond pads of 18 of the new device correspond with the connections 34, and are bonded thereto. This ease of changing out an inoperative device makes repair of the module very simple.

Figure 4 is a cross-sectional view through section 4-4 of Figure 3. Figure 4 illustrates that the semiconductor device 33 is in the opening 31 with interconnections 33 on the surface of the printed circuit board. For high power applications, a heat sink 40 may be placed under device 32 and bonded to the circuit board 30 to hold it in place. An insulating layer of film or epoxy material 41 is placed over the face of device 32 to protect the device and allow stacking of circuit boards as discussed below.

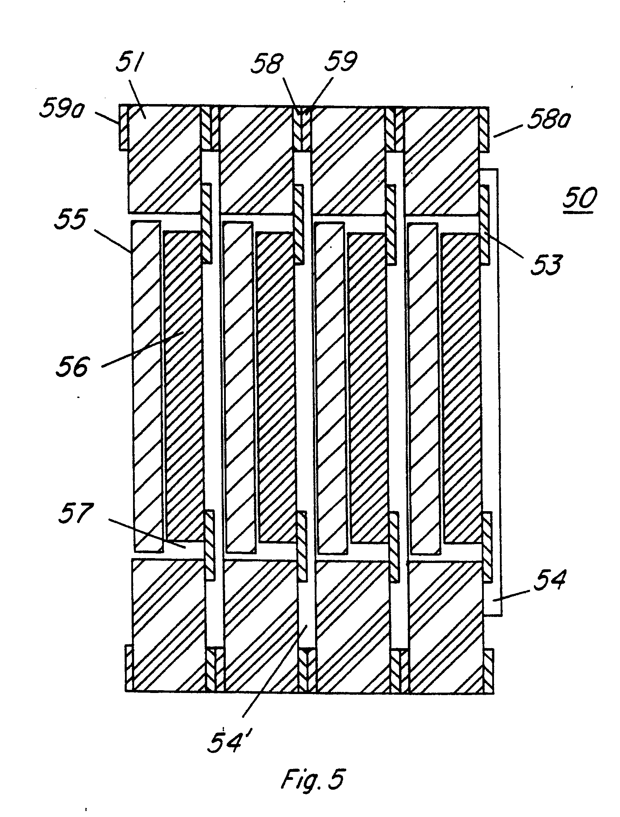

Figure 5 shows a stacked array 50 of devices according to the present invention. A plurality of circuit boards 51 are stacked, each board having an array of devices 56 mounted with in the opening 57. Also mounted within the openings 57 are heat sinks 55. The entire body of each device 56 and heat sink 55 is within the opening.

The only parts of the circuit extending out of the openings 57 are the circuit connections 53 which extend from the surface of a device 56 to the surface of a circuit board 51. An insulating material 54 is applied over the surface of the device and circuit board to protect, cover and insulate the circuitry and device from an adjacent board.

Although not illustrated, edge connectors such as those illustrated in Figure 2 may be formed at the edge of each circuit board 51, or a connecting board may be attached to and connected at an end of the module 50 to interconnected the boards 51 and allow input/output to the module. Contacts 58 and 59 are used to interconnect the circuit boards, and contacts 58a and 59a provide connections to the module.

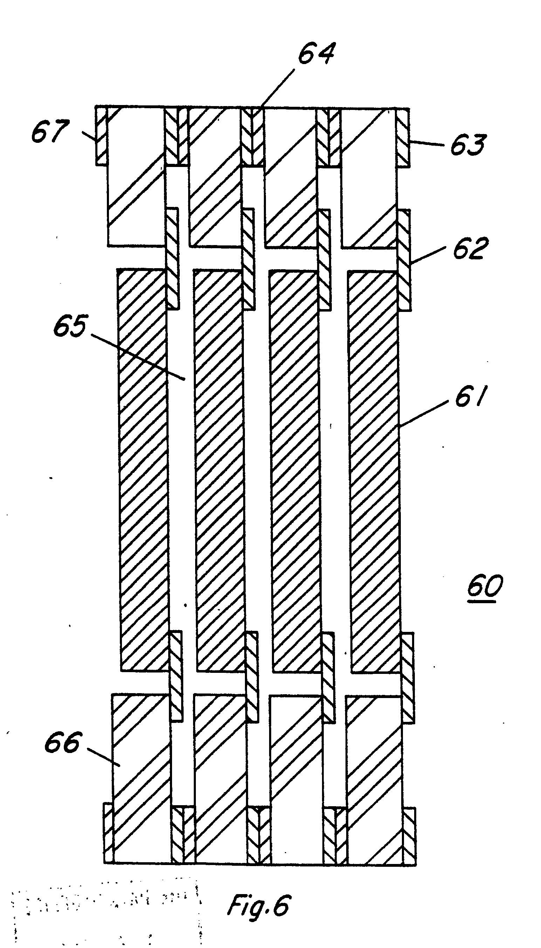

Figure 6 shows a stacked array of devices according to the present invention for high density memory packaging. There may be, for example, as many as fifty devices in some memory packaging. No heat sink or insulating material is used or needed in this application. If cooling is needed in the module, cooling air can be passed through the openings 65 between the devices. The array 60 has a plurality of devices 61 mounted in opening 65 in circuit boards 66. Each device 61 is mounted and interconnect to a circuit board 66 with contacts 62. Interconnections between the boards are shown at 63. External connections to the module may be made at 63 and 67. Immersion type (liquid) cooling systems can also be used at maximum heat dissipation efficiency with this type of packaging approach.

## Claims

1. The combination of a semiconductor device and printed circuit board structure comprising:
a printed circuit board having a plurality of openings through the board, and having circuitry on the board, part of which extends to the edge of some of the openings in the board;
raised contact pads on the circuit board connected with circuitry on the board; and
semiconductor devices, bonded to circuitry on an insulated base, placed in some of the openings in the printed circuit board such that part of the circuitry on the insulated base extends over the printed circuit board and connects with circuitry on the printed circuit board.

2. The combination according to claim 1, including passive electronic components in openings in the printed circuit board and connected with circuitry on the printed circuit board.

3. The combination according to claim 1, wherein a plurality of circuit boards are stacked to form a module and are electrically interconnected by said raised contact pads.

4. The combination according to claim 1, including a heat sink in the opening with a semiconductor device.

5. The combination according to claim 3, including an insulating material between the stacked boards.

6. The combination according to claim 1, wherein a semiconductor may be removed from the printed circuit board after mounting by cutting the insulating base and connections thereon.

7. A semiconductor packaging structure in which a plurality of semiconductor devices are mounted in openings on a continuous flexible base material, the base material having a repetitive pattern of conductors, one for each semiconductor device mounted in an opening, and the base material having two conductors extending the length of the continuous base material, comprising:
test pads formed on each of the conductors in the pattern of conductors;
each conductor in the pattern of conductors extending over the opening and connected to the semiconductor device mounted in the opening;
one of the two conductors extending the length of the continuous base material providing a power connection to each semiconductor device;

the other of the two conductors providing a ground connection to the semiconductor device; and

a fuse link between the power connection and each semiconductor device.

8. The semiconductor packaging structure according to claim 7, including a fuse link between the ground connection and the semiconductor device.

9. The semiconductor packaging structure according to claim 7, wherein each conductor in the pattern of conductors has a bond pad formed thereon.

10. The semiconductor packaging structure according to claim 7, wherein bond pads and test points are formed on the pattern of conductors, and the semiconductor device and part of the connection on the base material are removed by cutting between the bond pads and test points.

11. A circuit module including a stacked plurality of circuit boards, a plurality of semiconductor devices and circuit components interconnected on each circuit board and to other circuit boards in the module to form a desired functional electronic system, comprising:

a plurality of circuit boards having conductive circuitry on at least one surface and each circuit board having a plurality of openings through each board with at least part of the circuitry extending over some of the openings;

a plurality of semiconductor devices and/or electronic components mounted entirely within the openings in the circuit boards such that the semiconductor device and/or electronic component in the opening does not extend outside of the opening, and connected to the circuitry extending over the opening; and

contact pads formed at desired locations on the circuit boards such that when the circuit boards are stacked to form a module, the contact pads electrically connect with each other to interconnect the circuit boards.

12. The circuit module according to claim 11, including heat sinks located in at least some of the openings that have semiconductor devices therein.

13. The circuit module according to claim 11, including thin layers of insulating material between circuit boards to insulate the circuitry on one board from the adjacent board.

14. The circuit module according to claim 11, wherein the contact pads hold the circuit boards apart to provide air insulation between the circuitry between adjacent circuit boards.

Fig.1

EP 0 413 542 A2

Fig.2

EP 0 413 542 A2

Fig. 3

Fig. 4

Fig. 5

Fig.6